# EUROPÄISCHE PATENTANMELDUNG

(11) **EP 1 288 991 A2**
(43) Veröffentlichungstag der Anmeldung: **05.03.2003**
(21) Anmeldenummer: 02102241.3
(22) Anmeldetag: 29.08.2002
(51) Int. Cl.: H01H 85/44, H01H 85/046, H01H 85/46

(54) **Schutzschaltung für Kommunikationseinrichtungen**

(30) Priorität: 04.09.2001 DE 10143277
(71) Anmelder: SIEMENS AKTIENGESELLSCHAFT, 80333 München (DE)
(72) Erfinder: Steinhäuser, Lothar Dr., 17491, Greifswald (DE)

(57) **Zusammenfassung**

Zwischen den zweidrahtigen Anschluss (2) und der Kommunikationseinrichtung (3) ist jeweils ein als Überstrom-Sicherung wirkendes, durch gedruckte Leiterbahnen gebildetes Längsglied (5) eingefügt, denen ein als Überspannungsschutz wirkendes Querglied (6) nachgeschaltet ist. Die geometrische Ausgestaltung der Längsglieder (5) und die Anordnung sowie die Eigenschaften des Quergliedes (6) sind derart aufeinander abgestimmt, dass eine möglichst hohe thermische Rückkopplung vom Querglied (6) auf die Längsglieder (5) erreicht wird. Die Schutzschaltung kann kostengünstig realisiert werden und ist für hohe Anforderung an Überspannungs- und Überstromschutz geeignet.

## Beschreibung

In Kommunikationsnetzen sind für den Anschluss an die zweidrahtigen Übertragungsleitungen Schnittstellen in den Kommunikationseinrichtungen vorgesehen, wobei in die Übertragungsleitungen transiente Überspannungen eingekoppelt werden können oder die Übertragungsleitungen mit dem Niederspannungsnetz in Berührung kommen oder durch dieses in den Übertragungsleitungen Überspannungen indiziert werden. Um diese Schnittstellen vor diesen Überspannungen zu schützen, werden Schutzschaltungen verwendet, mit deren Hilfe die Überspannungen vor Erreichen der Kommunikationseinrichtung zumindest stark abgeschwächt bzw. eliminiert werden.

Die bisher verwendeten Schutzschaltungen sind überwiegend für zweidrahtige Datenschnittstellen vorgesehen und sind üblicherweise ein in Längsrichtung eingefügtes, auftretende transversal wirkende niederohmige Wechselspannungen begrenzendes Begrenzungselement und einem nachgeschalteten Querzweig gebildet, der durch Trisile oder Gasableiter realisiert ist, wobei die Trisile bzw. Gasableiter die gefährlichen Überspannungen begrenzen und kurzfristige hohe transiente Spannungsstösse wie beispielsweise durch sekundäre Blitzwirkungen abbauen - siehe hierzu "EMV/gerechtes Gerätedesign", Georg Durcansky, Seite 241, Francis-Verlag Muenchen,1992.

Da diese Schutzschaltungen meist in großen Stückzahlen produzierten Kommunikationseinrichtungen, insbesondere Netzanschluss- oder Netzabschlusseinrichtungen, eingesetzt werden, sind die Schutzschaltung derart zu konzipieren, dass eine möglichst wirtschaftliche Realisierung möglich ist. Des weiteren steigern die Betreiber von Kommunikationsnetzen die technischen Anforderungen an die Schutzschaltung hinsichtlich ihrer Wirkung zum Schutz vor Überspannungen und deren Einsetzbarkeit für unterschiedliche Schnittstellen ständig.

Die der Erfindung zugrundeliegende Aufgabe besteht darin, die Schutzschaltung hinsichtlich der hohen technischen Anforderungen und einer Realisierung mit geringstem wirtschaftlichen Aufwand zu verbessern. Die Aufgabe wird ausgehend von einer Schutzschaltung für den zweidrahtigen Anschluss von Kommunikationseinrichtungen an Kommunikationsnetze durch die kennzeichnenden Merkmale des Anspruchs 1 gelöst.

Der wesentliche Aspekt der erfindungsgemäßen Schutzschaltung ist darin zu sehen, dass zwischen den zweidrahtigen Anschluss und der Kommunikationseinrichtung jeweils ein als Überstrom-Sicherung wirkendes, durch gedruckte Leiterbahnen gebildetes Längsglied (5) eingefügt ist und den Längsgliedern ein als Überspannungsschutz wirkendes Querglied nachgeschaltet ist. Die geometrische Ausgestaltung der Längsglieder und die Anordnung sowie die Eigenschaften des Quergliedes sind derart aufeinander abgestimmt, dass eine möglichst hohe thermische Rückkopplung vom Querglied auf die Längsglieder erreicht wird. Der wesentlich Vorteil der erfindungsgemäßen Schutzschaltung besteht darin, dass durch die Verbindung der Eigenschaften von Trisils bzw. Gasableitern und der durch die gedruckten Leiterbahnen realisierten Sicherungselemente eine besonders wirtschaftliche Realisierung möglich ist, d.h. die Schutzschaltung kann kostengünstig produziert bzw. hergestellt werden. Ein weiterer Vorteil der Schutzschaltung besteht darin, dass bei hohen Stromstärken, die jedoch noch nicht zur Zerstörung der Überspannungssicherung führen, das Querglied und die Längsglieder derart angeordnet sind, dass durch die zusätzliche thermische rückkoppelnde Wirkung des Quergliedes auf die als Leiterbahnen ausgestaltete Längsglieder bzw. Überspannungssicherungen die Überstromsicherungen, d.h. die jeweiligen Leiterbahnen geschmolzen werden und somit ein durch zu starke Erwärmung des Quergliedes verursachter Schaden vermieden wird.

Vorteilhaft sind die Überspannungselemente durch einen Trisil - Anspruch 2 - oder durch einen Gasableiter - Anspruch 3 - realisiert, wobei bei einem Einsatz von Trisils eine Überspannung mehr reduziert wird als beispielsweise bei Einsatz von Leistungs-Zener-Dioden.

Durch die spezielle Ausgestaltung hinsichtlich der thermischen Rückkopplung ist die Schutzschaltung vor eine Schnittstelle geschaltet oder in diese integriert und diese ist als Datenschnittstelle oder als Schnittstelle zur Übertragung von analogen Signalen ausgestaltet - Anspruch 6.

Weitere vorteilhafte Ausgestaltungen der erfindungsgemäßen Schutzschaltung für Kommunikationseinrichtungen sind den weiteren Ansprüchen zu entnehmen.

Die erfindungsgemäße Schutzschaltung wird im folgenden anhand zweier Zeichnungen näher erläutert. Dabei zeigen
- Figur 1: in einem Blockschaltbild die Schaltung der Schutzschaltung und
- Figur 2: ein Layout einer Realisierung der Schutzschaltung auf einer Leiterplatte einer Kommunikationseinrichtung.

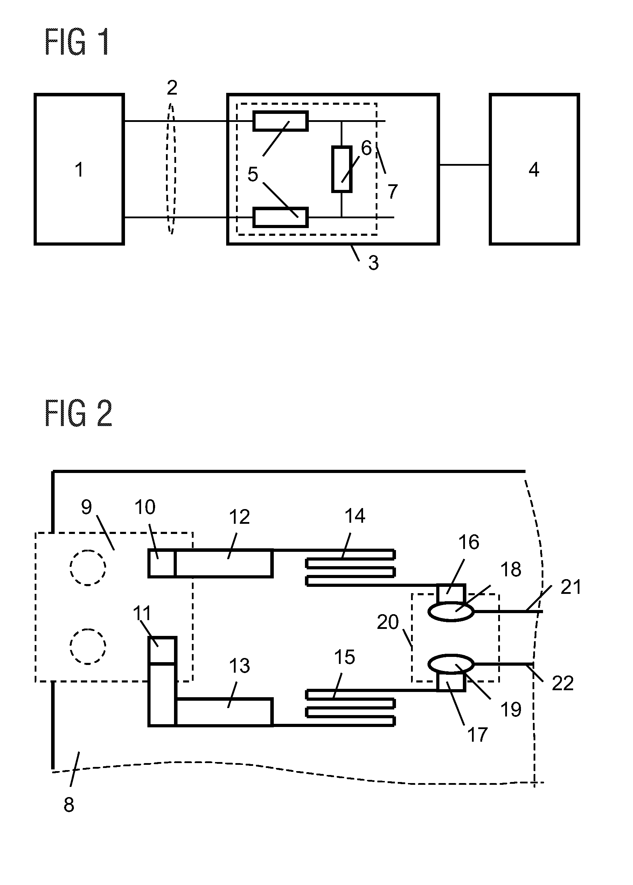

Figur 1 zeigt eine Vermittlungseinrichtung 1 - beispielsweise eine ISDN-Vermittlungseinrichtung -, an die über eine zweidrahtige Anschlussleitung 2 eine Kommunikationseinrichtung 3 - beispielsweise eine ISDN- Netzabschlusseinrichtung (NTBA) - angeschlossen ist. Die Kommunikationseinrichtung 3 ist mit einem Endgerät 4 verbunden, wobei von der Vermittlungseinrichtung 1 analog an die Kommunikationseinrichtung 3 übermittelte Daten digital an das Endgerät weitergeleitet werden.

In der Kommunikationseinrichtung 3 sind die beiden Drähte der Anschlussleitung ASL jeweils mit einem Längsglied 5 verbunden, wobei die Längsglieder als Sicherungselemente zur Vermeidung eines zu hohen Stromflusses von der Anschlussleitung 2 zur Kommunikationseinrichtung 3 vorgesehen sind. Zwischen die Ausgänge der Längsglieder 5 ist ein Überspannungen abbauendes Querglied 6 geschaltet, wobei die Ausgänge auch zu den nicht dargestellten Komponenten der Kommunikationseinrichtung 3 geführt sind. Die Längsglieder 5 und das Querglied 6 bilden zusammen ein Halbglied bzw. die erfindungsgemäße Schutzschaltung 7.

In der Figur 2 ist eine Realisierung der Schutzschaltung 7 aufgezeigt, wobei die Schutzschaltung 7 auf einer Leiterplatte 8 der Kommunikationseinrichtung 3 angeordnet ist. Im Ausführungsbeispiel ist derjenige Bereich der Leiterplatte 8 dargestellt, auf dem die Schutzschaltung 7 ausgestaltet ist. Im Randbereich der Leiterplatte 8 ist auf dieser für den physikalischen Anschluss der einzelnen Leitungen der zweidrahtigen Anschlussleitung 2 eine Leitungsbuchse 9 - durch ein strichliertes Rechteck angedeutet - aufgebracht, wobei die physikalischen Anschlüsse durch zwei strichlierte Kreise angedeutet sind. Elektrisch verbunden sind die für die Verbindung mit der Leiterplatte 8 vorgesehenen Anschlüsse der Leitungsbuchse 9 mit jeweils einem Lötanschluss 10,11 der Leiterplatte 8, wobei die beiden Lötanschlüsse 10,11 im zum Innenbereich der Leiterplatte 8 gewandten Randbereich der Leitungsbuchse 9 angeordnet sind. Von diesen beiden Lötanschlussen 10,11 ist jeweils eine zum Innenbereich der Leiterplatte 8 gerichtete, rechteckförmige Leiterbahn 12,13 annähernd parallel zum Rand der Leiterplatte 8 ausgestaltet. Die Breite der Leiterbahnen 12,13 ist hierbei derart zu wählen, dass ein Strom mit maximal erlaubter Stromstärke von der Anschlussleitung zu den nachfolgenden Komponenten fließen kann. Die Stromstärke ist hierbei insbesondere von den Anforderungen der Betreiber der Vermittlungseinrichtungen 1 und der Kommunikationseinrichtungen 3, d.h. der Betreiber der Kommunikationsnetze abhängig.

Die beiden Leiterbahnen 12,13 enden jeweils in einer mäanderförmig geführten Leiterbahn 14,15, die eine wesentlich geringere Breite - beispielsweise 0,1..0,2 mm - aufweist und deren Längen etwa im Bereich von 5 bis 10 mm liegen. Die Längsseiten der mäanderförmig geführten Leiterbahnen verlaufen hierbei annähernd parallel zum Rand der Leiterplatte 8. Durch die mäanderförmige Führung - in der Zeichnung sind jeweils drei von im Ausführungsbeispiel angenommenen sechs Wendungen dargestellt - wird eine induktive Wirkung erzeugt, mit deren Hilfe transversal wirkende niederohmige Wechselspannungen abgebaut werden können. Des weiteren sind die geometrischen Eigenschaften - Dicke und Breite - der mäanderförmig geführten Leiterbahnen 14,15 derart gewählt, dass bei einer vorgegebenen Stromstärke diese Leiterbahnen 14,15 schmelzen und somit eine Überstrom-Sicherung repräsentieren.

Jeweils ein zum Innenbereich der Leiterplatte 8 gerichtetes Ende der mäanderförmig geführten Leiterbahn 14,15 ist mit einer rechteckförmigen Zugangsleiterbahn 16,17 verbunden, dessen Breite annähernd der rechteckigen Leiterbahn 11,13 entspricht. Die Zugangsleiterbahnen 16,17 sind zueinander gerichtet und enden jeweils in einem ovalen Anschlussbereich 18,19, der jeweils für den Lötanschluss eines Anschlusses eines das Querglied bildenden Trisils 20 vorgesehen ist. Die Anschlussbereiche 18,19 sind hierbei auf die geometrische Ausgestaltung der Anschlüsse der Trisils 20, d.h. dessen Ausdehnung und Abstand abgestimmt. Ein Trisil 20 stellt ein Halbleiterelement dar, dass bei großen Überspannungen sehr niederohmig wird und somit auch auf der Anschlussleitung 2 auftretende Überspannungen und kurzzeitig hohe transiente Spannungsstösse reduzieren bzw. abbauen kann.

In einem kritischen Fall einer Berührung der Leiter der Anschlussleitung 2 mit einem Niederspannungsnetz, beispielsweise dem 220V-Niederspannungsnetz, kann die Stromstärke des über die Anschlussleitung fließenden Stromes gerade so hoch sein, dass die als Überstrom-Sicherung wirkenden mäanderförmig geführten Leiterbahnen 14,15 noch nicht schmelzen, der Trisil 20 aufgrund der Überspannung ständig überlastet ist und durch die Dauerüberlastung sich erwärmt, erhitzt und anschließend verkohlen oder sogar verbrennen würde, wodurch große Schäden an der Kommunikationseinrichtung 3 und ggfs. in weiteren Einrichtungen oder Gebäuden verursacht werden können. Um dies erfindungsgemäß zu vermeiden ist das Querglied bzw. der Trisil 20 derart angeordnet, dass eine thermische Rückkopplung auf die Längszweige und damit auf die als Überstrom-Sicherung wirkenden, mäanderförmig geführten Leiterbahnen 14,15 erreicht wird. Dies bedeutet, dass der Trisil 20 derart nahe an den als Überstrom-Sicherungen wirkenden, mäanderförmig geführten Leiterbahnen 14,15 angeordnet ist, dass er diese bei eigener starker Erwärmung bzw. Erhitzung zusammen mit der ggfs. dort bereits vorhandenen Wärme zum schmelzen bringt. Hierbei sind die geometrischen Ausgestaltungen der Leiterbahnen 14..19 und die Auswahl des Trisils 20 hinsichtlich seiner Überspannungseigenschaften aufeinander abzustimmen, d.h. die geometrische Ausgestaltung der Leiterbahnen 14..19 und die Auswahl des Trisils 20 sind auf die aktuellen physikalischen Anforderungen der jeweiligen Betreiber der Kommunikationseinrichtungen bzw. Kommunikationsnetze derart abzustimmen, dass eine thermische Rückkopplung erreicht wird.

Alternativ kann ein Gasableiter oder eine Leistungs-Zehner-Diode als Querglied verwendet werden, wobei die Leiterbahnen 14..19 entsprechend zu dimensionieren sind, dass eine thermische Rückkopplung entsteht. Besonders geeignet als Querglied sind auch Crow Bar Elemente, die im Überlastfall, d.h. bei hohen Überspannungen kurzschließen und so die Kommunikationseinrichtungen 3 besser vor Überspannungen schützen. Von den Anschlussbereichen 18,19 ist jeweils eine rechteckförmige Leiterbahn 21,22 zu den weiteren, nicht dargestellten Komponenten der Kommunikationseinrichtung 3 geführt, wobei deren geometrische Ausgestaltung auf die zu übermittelnden Signale und Energie abgestimmt sind.

Die erfindungsgemässe Schutzschaltung ist nicht auf das Ausführungsbeispiel begrenzt, sondern kann in allen Schnittstellen und Kommunikationseinrichtungen verwendet werden, die mit Leitungen - Datenleitungen oder Übertragungsleitungen - verbunden sind und bei denen ein Schutz vor kurzzeitigen und ständigen Überspannungen und Überströmen gefordert ist. Dies können sowohl Schnittstellen sein, über die Daten, als auch Schnittstellen, über die analoge Signale wie beispielsweise Sprachsignale oder Signale von Fax-Einrichtungen, übertragen werden. Des weiteren kann die Schutzschaltung auf einer separaten Leiterplatte realisiert werden, die nach einem Schmelzen der als Überstrom-Sicherung wirkenden mäanderförmig geführten Leiterbahnen 14,15 oder des Trisils 20 ausgetauscht werden kann.

## Patentansprüche

1. Schutzschaltung für den zweidrahtigen Anschluss von Kommunikationseinrichtungen an Kommunikationsnetze
**dadurch gekennzeichnet,**
**dass** zwischen den zweidrahtigen Anschluss (2) und der Kommunikationseinrichtung (3) jeweils eine als Überstrom-Sicherung wirkendes, durch gedruckte Leiterbahnen gebildetes Längsglied (5) eingefügt ist,
**dass** den Längsgliedern (5) ein als Überspannungsschutz wirkendes Querglied (6) nachgeschaltet ist, und
**dass** die geometrische Ausgestaltung der Längsglieder (5) und die Anordnung sowie die Eigenschaften des Quergliedes (6) derart aufeinander abgestimmt sind, dass eine möglichst hohe thermische Rückkopplung vom Querglied (6) auf die Längsglieder (5) erreicht wird.

2. Schutzschaltung nach Anspruch 1, **dadurch gekennzeichnet, dass** das Querglied durch einen Trisil (6) realisiert ist.

3. Schutzschaltung nach Anspruch 1, **dadurch gekennzeichnet, dass** das Querglied durch einen Gasableiter realisiert ist.

4. Schutzschaltung nach einem der Ansprüche 1 bis 3, **dadurch gekennzeichnet,**
**dass** die die Längsglieder (5) bildenden Leiterbahnen (14,15) geometrisch als Induktivität oder als magnetisch gekoppelte Induktivität ausgestaltet sind.

5. Schutzschaltung nach Anspruch 4, **dadurch gekennzeichnet, dass** die Leiterbahnen (14,15) mäanderförmig geführt sind und die Breite und die Dicke der Leiterbahnen (14,15) auf eine maximale Stromstärke eines durch Leiterbahnen (14,15) fließenden Stromes abgestimmt sind.

6. Verwendung der Schutzschaltung zu einer Schnittstelle einer Kommunikationseinrichtung, **dadurch gekennzeichnet,**
**dass** die Schutzschaltung (7) vor eine Schnittstelle geschaltet oder in diese integriert ist und diese als Datenschnittstelle oder als Schnittstelle zur Übertragung von analogen Signalen ausgestaltet ist.
